# EUROPEAN PATENT APPLICATION

(11) **EP 4 567 958 A1**
(43) Date of publication of application: **11.06.2025**
(21) Application number: 23851309.7
(22) Date of filing: 19.05.2023
(51) Int. Cl.: H01M 10/42

(54) **BATTERY, ELECTRICAL APPARATUS, BATTERY TESTING SYSTEM, AND BATTERY TESTING METHOD**

(30) Priority: 10.08.2022 CN 202210957601
(71) Applicant: Contemporary Amperex Technology Co., Limited, Ningde, Fujian 352100 (CN)
(72) Inventor: LIAN, Dengwei, Ningde, Fujian 352100 (CN); ZHAO, Tong, Ningde, Fujian 352100 (CN); CHEN, Chen, Ningde, Fujian 352100 (CN); LI, Yanghu, Ningde, Fujian 352100 (CN); ZHAO, Bin, Ningde, Fujian 352100 (CN)
(74) Representative: Thoma, Michael
(86) International application number: PCT/CN2023/095349
(87) International publication number: WO 2024/032079

(57) **Abstract**

The present application provides a battery, an electrical apparatus, a battery testing system and a battery testing method. The battery includes a battery module and a wireless management module. The wireless management module is configured to provide a function of communication between the battery module and an external device; that is, the wireless management module receives command data sent by the external device, sends command parameters corresponding to the command data to the battery module, receives battery parameters sent by the battery module, and sends battery data corresponding to the battery parameters to the external device. The embodiments of the present application provide the battery with a wireless communication function, such that the battery can send the battery data to the external device through wireless communication, thereby improving convenience of transmission of the battery parameters.

## Description

### Cross-Reference to Related Applications

The present application claims the priority to Chinese Patent Application No. 202210957601.6 filed on August 10, 2022 and entitled "BATTERY, ELECTRICAL APPARATUS, BATTERY TESTING SYSTEM AND BATTERY TESTING METHOD", the entire contents of which are incorporated herein by reference.

### Technical Field

The present application relates to the field of batteries, and more particularly relates to a battery, an electrical apparatus, a battery testing system and a battery testing method.

### Background

There are many types of batteries currently on the market, such as chemical batteries, physical batteries, and bio-batteries, and the chemical batteries further include nickel-chromium batteries, nickel-metal hydride batteries, lead-acid batteries and lithium-ion batteries. The lithium-ion batteries are currently one type of the widely used batteries.

Taking the lithium-ion battery as an example, a current method for obtaining battery-related parameters in the lithium-ion battery adopts a manner of connecting the lithium-ion battery by a wire harness, but the manner is complex in operation, and low in efficiency of obtaining the battery-related parameters.

### Summary of the Invention

An objective of embodiments of the present application is to provide a battery, an electrical apparatus, a battery testing system and a battery testing method, so as to provide a battery facilitating acquisition of battery-related parameters.

In a first aspect, an embodiment of the present application provides a battery, including a battery module and a wireless management module. The wireless management module is configured to provide a function of communication between the battery module and an external device; that is, the wireless management module receives command data sent by the external device, sends command parameters corresponding to the command data to the battery module, receives battery parameters sent by the battery module, and sends battery data corresponding to the battery parameters to the external device.

The embodiments of the present application provide the battery with a wireless communication function, such that the battery can send the battery data to the external device through wireless communication, thereby improving convenience of transmission of the battery parameters.

In any embodiment, the battery module includes a battery cell and a battery management system (BMS), where the BMS is connected to the battery cell and the wireless management module respectively; and the BMS is configured to collect battery parameters of the battery cell and send battery data corresponding to the battery parameters to the wireless management module.

In this embodiment of the present application, the BMS is connected to the wireless management module, such that the wireless management module can send the battery parameters, monitored by the BMS, of the battery cell to the external device through wireless communication, thereby improving the convenience of data transmission.

In any embodiment, the wireless management module is configured to convert the signal type of the command data into the signal type adaptive to the BMS, and send the converted command parameters to the BMS.

In this embodiment of the present application, because the signal type of the command data received by the wireless management module from the external device is the wireless signal, to facilitate the BMS to recognize the command data, the wireless management module converts the wireless signal into the signal type that the BMS can recognize.

In any embodiment, the wireless management module is further connected to a power supply to adjust a sampling voltage of the power supply, and wake up the BMS through the adjusted sampling voltage.

In this embodiment of the present application, the wireless management module may wake up the BMS by connecting to the power supply, so as to prepare for sending the battery parameters to the external device later.

In any embodiment, the power supply is a battery module; and the wireless management module is connected to a low-voltage interface of the battery module through a first wire harness, where the low-voltage interface refers to an interface whose output voltage is lower than a preset voltage.

In this embodiment of the present application, the wireless management module is connected to the low-voltage interface of the battery module through the first wire harness, so as to realize the function of supplying power to the battery.

In any embodiment, the wireless management module is connected to a high-voltage loop of the battery through a second wire harness.

In this embodiment of the present application, the wireless management module is connected to the high-voltage loop of the battery through the second wire harness, such that the high-voltage loop of the battery supplies power to a low-voltage loop of the battery.

In any embodiment, the battery is used to be in communication connection with a test terminal, and before the battery arrives at a test station, or after the battery arrives at the test station, or after the battery leaves the test station, testing of wireless test items is started.

This embodiment of the present application uses the wireless test method, which improves the flexibility of the test, reduces the number of test items of a wired test through electrical connection on the test station, and shortens the test time on the test station.

In any embodiment, the wireless test items include at least one of a BMS master control test, a BMS slave control test, a minimum voltage test, a maximum voltage test, a minimum temperature test, a maximum temperature test, a state of charge (SOC) detection, an interlocking signal fault detection, a trickle charge function detection and a fast-charging function detection.

In this embodiment of the present application, the above-mentioned test items capable of being completed through wireless communication are used to realize data interaction between the battery-to-be-tested and the test terminal by using the wireless management module, and complete the wireless test, thereby reducing the test items of the wireless test on the battery-to-be-tested on the test station, and improving test efficiency.

In a second aspect, an embodiment of the present application provides an electrical apparatus, including the battery described in the first aspect, and the battery is used to provide electric energy and send, through wireless communication, battery data corresponding to battery parameters to an external device.

In a third aspect, an embodiment of the present application provides a battery testing system, including a test terminal and the battery provided in the first aspect; and the battery is in wireless communication connection with the test terminal through a wireless management module;

the battery receives, by the wireless management module, a test command sent by the test terminal, acquires corresponding battery parameters according to the test command, and sends, by the wireless management module, test data corresponding to the battery parameters to the test terminal.

In this embodiment of the present application, the battery is in wireless communication connection with the test terminal through the wireless management module, such that the wireless test on the battery-to-be-tested can be realized, thereby reducing test items of a wired test on a test station, reducing a test cycle on the test station, and improving test efficiency.

In a fourth aspect, an embodiment of the present application provides a battery testing method. The battery includes a wireless management module. The method includes: receiving, by the wireless management module, a test command sent by a test terminal, and acquiring corresponding battery parameters according to the test command; and returning, by the wireless management module, test data corresponding to the battery parameters to the test terminal, thereby realizing the wireless test on the battery.

This embodiment of the present application implements the battery test through wireless communication, accordingly, the test items capable of being performed through the wireless test can be performed before the battery arrives at a test station, or after the battery leaves the test station, or may be performed in parallel with a wired test on the test station, such that the test items on the test station are reduced, thereby reducing a test cycle on the test station and improving test efficiency.

In any embodiment, the test terminal monitors position information of the battery, and if the position information represents that the battery arrives at a preset station, the test command is sent to the wireless management module.

In this embodiment of the present application, the test terminal monitors the position of the battery and starts the wireless test after the battery arrives at the preset station, such that part of test items are performed through the wireless test, which does not occupy test time on the test station, thereby improving test efficiency.

In any embodiment, before the wireless management module receives the test command sent by the test terminal, the method further includes: receiving a connection request sent by the test terminal; and establishing, by the wireless management module, a wireless communication connection with the test terminal according to the connection request, and waking up the BMS.

In this embodiment of the present application, the wireless communication connection with the test terminal is established by the wireless management module, so as to provide a communication basis for the subsequent wireless test.

In any embodiment, the test command includes at least one of a BMS master control test command, a BMS slave control test command, a minimum voltage test command, a maximum voltage test command, a minimum temperature test command, a maximum temperature test command, an SOC detection command, an interlocking signal fault detection command, a trickle charge function detection command and a fast-charging function detection command.

In this embodiment of the present application, the above-mentioned test items capable of being completed through wireless communication are used to realize data interaction between the battery-to-be-tested and the test terminal by using the wireless management module, and complete the wireless test, thereby reducing the test items of the wireless test on the battery-to-be-tested on the test station, and improving test efficiency.

Other features and advantages of the present application will be set forth in the following specification, and some will be apparent from the specification, or may be learned by implementing the embodiments of the present application. The objectives and other advantages of the present application may be realized and obtained by structures particularly pointed out in the written specification, claims and drawings.

### Description of Drawings

To more clearly describe the technical solutions of the embodiments of the present application, the drawings to be used in the embodiments of the present application will be briefly introduced below, and it should be understood that the following drawings only illustrate some embodiments of the present application, and therefore should not be considered as limiting the scope. For those of ordinary skill in the art, other relevant drawings may also be obtained based on these drawings without creative efforts.
Fig. 1 is a schematic structural diagram of a battery according to an embodiment of the present application;
Fig. 2 is a schematic structural diagram of another battery according to an embodiment of the present application.
Fig. 3 is an exploded schematic structural diagram of a battery cell according to some embodiments of the present application.
Fig. 4 is a structural diagram of a connection between a battery and a power supply according to an embodiment of the present application;
Fig. 5 is a structural diagram of another connection among a battery, a power supply and an external device according to an embodiment of the present application;
Fig. 6 is a structural diagram of another connection among a battery, a power supply and an external device according to an embodiment of the present application;
Fig. 7 is a schematic diagram of a semi-finished product test according to an embodiment of the present application;
Fig. 8 is a schematic diagram of a pre-shipment detection of finished products in stock according to an embodiment of the present application;
Fig. 9 is a schematic structural diagram of a battery testing system according to an embodiment of the present application;
Fig. 10 is a schematic flowchart of a battery testing method according to an embodiment of the present application;
Fig. 11 is a schematic flowchart of another battery testing method according to an embodiment of the present application; and
Fig. 12 is a schematic diagram of a display interface of a test terminal according to an embodiment of the present application.

### Detailed Description

Embodiments of technical solutions of the present application are described in detail below in conjunction with drawings. The following embodiments are only used to more clearly describe the technical solutions of the present application, and therefore are only used as examples but cannot be used to limit the scope of protection of the present application.

Unless otherwise defined, all technical and scientific terms used herein have the same meaning as commonly understood by those skilled in the art belonging to the technical field of the present application; the terms used herein are only for the purpose of describing the specific embodiments and are not intended to limit the present application; the terms "including" and "having" and any variations thereof in the specification and the claims of the present application and in the description of drawings above are intended to cover non-exclusive inclusion.

In the description of the embodiments of the present application, the technical terms "first", "second", etc. are used only to distinguish different objects, but not to be understood as indicating or implying a relative importance or implicitly specifying the number, particular order, or primary and secondary relationship of the indicated technical features. In the description of the embodiments of the present application, "a plurality of" means two or more, unless otherwise explicitly and specifically defined.

A reference herein to "an embodiment" means that a particular feature, structure, or characteristic described in combination with the embodiments can be included in at least one embodiment of the present application. The appearance of this phrase in various places in the specification does not necessarily refer to the same embodiment, nor is it a separate or alternative embodiment that is mutually exclusive from other embodiments. It is explicitly and implicitly understood by those skilled in the art that the embodiments described herein may be combined with other embodiments.

In the description of the embodiments of the present application, the term "and/or" is only an association relationship for describing associated objects, indicating that there may be three relationships, for example, A and/or B may represent three situations: A exists alone, both A and B exist, and B exists alone. In addition, the character "/" herein generally means that the associated objects before and after it are in an "or" relationship.

In the description of the embodiments of the present application, the term "a plurality of" refers to two or more (including two), and similarly, "multiple groups" refers to two or more groups (including two groups), and "multiple sheets" refers to two or more sheets (including two sheets).

In the description of the embodiments of the present application, the orientation or position relationship indicated by the technical terms "center", "longitudinal", "transverse", "length", "width", "thickness", "upper", "lower", "front", "back", "left", "right", "vertical", "horizontal", "top", "bottom", "inner", "outer", "clockwise", "anticlockwise", "axial direction", "radial direction", "circumferential direction", etc. are based on the orientation or position relationship shown in the drawings and are intended to facilitate the description of the embodiments of the present application and simplify the description only, rather than indicate or imply that an apparatus or element referred to must have a particular orientation or be constructed and operated in a particular orientation, and therefore are not to be understood as limitations on the embodiments of the present application.

In the description of the embodiments of the present application, unless otherwise expressly specified and limited, the technical terms "mount", "link", "connect" and "fix" should be understood in a broad sense, such as, a fixed connection, a detachable connection, or an integrated connection; a mechanical connection, or an electrical connection; and a direct connection, an indirect connection through an intermediate medium, an internal communication of two elements, or interaction between two elements. Those of ordinary skill in the art can understand the specific meanings of the above terms in the embodiments of the present application according to specific situations.

At present, batteries used as new energy are widely applied to various fields, such as hydraulic, thermal power and solar power stations and other energy storage power systems, and may also be applied to electric vehicles, such as electric bicycles, electric motorcycles and electric cars.

The production technological process of a power battery includes a testing process. When the power battery arrives at a test station corresponding to the testing process, the power battery will be tested in a pre-offline stage to ensure that the quality of the power battery leaving the factory meets the requirements. At present, an EOL (end of line) comprehensive testing system is used for off-line testing of the power batteries. The EOL comprehensive testing system combines multiple functions such as a battery charge and discharge test, a battery safety regulation detection, a battery parameter test, a BMS (Battery management system) test and an auxiliary function test. Through device integration, bar code binding, automatic test start, and automatic judgment of test results are used to realize the full intelligence and automation of the entire workflow, so as to reduce operators and improve test efficiency.

The inventor notices that since there are many test items to be performed in the pre-offline stage, the test cycle of each power battery on the test station is relatively long, which brings about the problem of low test efficiency. In order to meet the takt requirements of the entire production line, it is necessary to reserve more test stations when the production line is built.

In order to solve the above-mentioned problem of low battery test efficiency, the inventor of the present application finds that among multiple test items, some test items may be wirelessly performed, that is, the test can be realized through wireless communication between a battery-to-be-tested and a test terminal, and the battery-to-be-tested does not need to be electrically connected to a test probe on the test station before the test starts.

Based on the above considerations, an embodiment of the present application provides a battery, including a battery module and a wireless management module. The wireless management module is configured to make the battery have a wireless communication function so as to be in wireless communication connection with an external device, and to send, in a wireless manner, battery data corresponding to battery parameters to the external device Therefore, the convenience of transmission of the battery parameters can be improved.

The battery provided by this embodiment of the present application may be a power battery or an energy storage battery. When the battery is used as the power battery, the power battery may be used in electrical apparatuses such as a vehicle, a ship, or an aircraft, but is not limited thereto. In addition, the battery provided by this embodiment of the present application can be used to realize the wireless transmission of the battery parameters before going offline, before leaving a warehouse, or when installed in the electrical apparatus, for example, functions such as the wireless test on the battery can be realized.

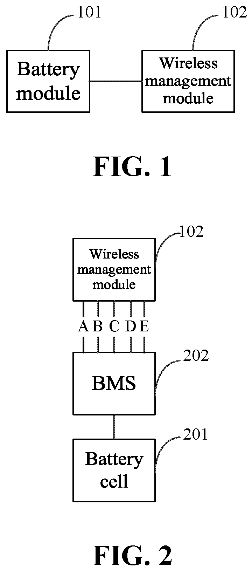

Fig. 1 is a schematic structural diagram of a battery according to an embodiment of the present application. As shown in Fig. 1, the battery includes a battery module 101 and a wireless management module 102. The wireless management module 102 is configured to provide a function of communication between the battery module 101 and an external device. That is, the wireless management module 102 receives command data sent by the external device, and sends command parameters corresponding to the command data to the battery module 101. In addition, the wireless management module 102 may also be configured to receive battery parameters sent by the battery module 101, and send battery data corresponding to the battery parameters to the external device.

In a specific implementation process, the battery module 101 may be understood as a battery body, which is configured to provide electric energy and generate the battery parameters. The battery parameters are parameters of the battery body, such as a minimum voltage, minimum and maximum voltages, a minimum temperature, a maximum temperature, an SOC (State of charge) value, which are not specifically limited in this embodiment of the present application.

The battery inside includes the wireless management module 102 and the battery module 101 which are connected and may be electrically connected through a wire harness, or electrically connected in a physical contact manner. For example: the wireless management module 102 is provided with a male interface, and the battery module 101 is provided with a female interface adaptive to the male interface. The wireless management module 102 may be inserted into the female interface of the battery module 101 through the male interface to realize a connection between the wireless management module 102 and the battery module 101. It can be understood that the female interface may also be arranged in the wireless management module 102, and the male interface adaptive to the female interface is arranged in the battery module 101.

The wireless management module 102 may establish a communication connection with the external device, where the external device may be an electronic device for testing the battery, or an electronic device for recording the battery parameters. The electronic device may be a terminal device or a server; the terminal device may specifically be a smart phone, a tablet, a computer, a personal digital assistant (Personal Digital Assistant, PDA), etc.; and the server may specifically be an application server or a Web server. After the wireless management module establishes the communication connection with the external device, the wireless management module 102 may receive the command data sent by the external device, and send the command parameters corresponding to the command data to the battery module. The command parameters may be configured to obtain one or more battery parameters of the battery module 101. For example: the command data includes 20-byte data, and the wireless management module 102 parses the received 20-byte data to obtain one ID and 8-byte data. It can be understood that the one ID and the 8-byte data constitute the command parameters, and then the command parameters are sent to the battery module 101. It can be understood that the above is just an example, and the specific content in the command data sent by the external device to the wireless management module 102 may be determined according to actual conditions. In some embodiments, the wireless management module 102 may only convert signal types of the command data without modifying the content, which can be understood that the command data sent by the external device to the wireless management module 102 is identical to the command parameters sent to the battery module 101. After the battery module 101 receives the command parameters sent by the wireless management module 102, the corresponding battery parameters are acquired according to the command data, and the battery data corresponding to the battery parameters is sent to the wireless management module102 and sent by the wireless management module 102 to the external device in a wireless manner. For example: the battery parameters include one ID and 8-byte parameters, the wireless management module 102 converts the received ID into a new byte, the new byte is combined with the received 8-byte data to form new 20-byte battery data, and then the battery data is sent to the external device. It can be understood that the above is just an example, and the specific content in the battery parameters sent by the battery module 101 to the wireless management module 102 may be determined according to actual conditions. In some embodiments, the wireless management module 102 may only convert signal types of the battery parameters without modifying the content, which can be understood that the battery parameters sent by the battery module 101 to the wireless management module 102 are identical to the battery data sent to the external device.

It can be understood that after the wireless management module 102 establishes the wireless communication connection with the external device, the battery module 101 can spontaneously send the battery parameters to the wireless management module 102, and the wireless management module 102 sends the battery data corresponding to the battery parameters to the external device. The battery parameters may be product information corresponding to the battery, such as battery bar code, software version and other information.

This embodiment of the present application provides the battery with a wireless communication function, such that the battery can send the battery parameters to the external device through wireless communication, thereby improving convenience of transmission of the battery parameters.

Based on the above embodiment, the battery module includes a battery cell and a battery management system (BMS), where the BMS is respectively connected with the battery cell and the wireless management module, and is configured to collect battery parameters of the battery cell and send the battery data corresponding to the battery parameters to the wireless management module.

Fig. 2 is a schematic structural diagram of another battery according to an embodiment of the present application. As shown in Fig. 2, a battery module includes a battery cell 201 and a battery management system (BMS) 202, and a wireless management module is connected to the BMS 202. As shown in Fig. 2, the wireless management module 102 is connected to the BMS 202 through five wires, where a wire A is configured to wake up the BMS 202, a wire B and a wire C are controller area network (CAN) buses for data interaction, and a wire D and a wire E are configured to power the BMS system 202. It can be understood that the five wires shown in Fig. 2 are just for an exemplary purpose. In practical application, the wireless management module and the BMS may be connected through more or fewer wires, which is not specifically limited in this embodiment of the present application.

The battery module may include a plurality of battery cells 201 which are connected in series or parallel or be in parallel-series connection. The parallel-series connection means that the plurality of battery cells 201 are connected both in series and parallel. The plurality of battery cells 201 may be directly connected in series, or in parallel or be in parallel-series connection together; and of course, the battery may also be in a form of battery modules formed by first connecting the plurality of battery cells 201 in series, or in parallel or be in parallel-series connection, and the plurality of battery modules are then connected in series, or in parallel or be in parallel-series connection into a whole. The battery may further include other structures, for example, the battery may further include a convergence component for electrically connecting the plurality of battery cells.

Each battery cell 201 may be a secondary battery or a primary battery; or may be a lithium-sulfur battery, a sodium-ion battery or a magnesium-ion battery, but is not limited thereto. The battery cell 201 may be in a cylindrical, flat or rectangular solid shape or in other shapes.

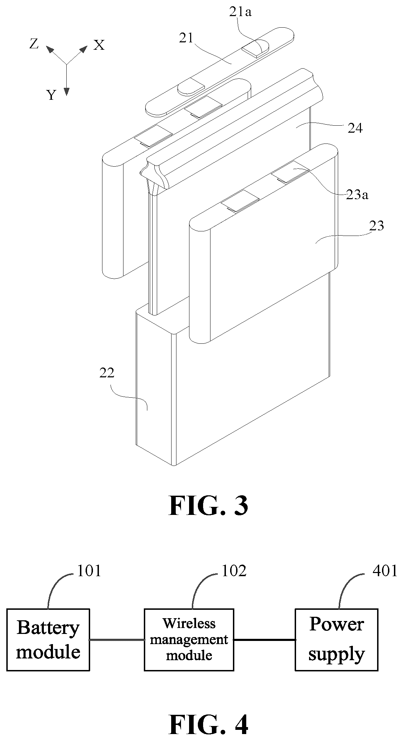

Please refer to Fig. 3, and Fig. 3 is a schematic diagram of a breakdown structure of a battery cell according to some embodiments of the present application. The battery cell refers to the smallest unit constituting the battery. As shown in Fig. 3, the battery cell includes an end cover 21, a case 22, a cell assembly 23 and other functional components.

The end cover 21 is a component covering an opening of the case 22 to isolate an internal environment of the battery cell 20 from the external environment. Without limitation, the shape of the end cover 21 may be adaptive to the shape of the case 22 so as to be matched with the case 22. Optionally, the end cover 21 may be made of a material (e.g., an aluminum alloy) with a certain hardness and strength, accordingly, the end cover 21 is not easily deformed when being subject to extrusion and collisions, such that the battery cell 20 can have higher structural strength, and safety performance can also be improved. Functional components such as electrode terminals 21a may be arranged on the end cover 21. The electrode terminals 21a can be used for being electrically connected to the cell assembly 23 for outputting or inputting electric energy of the battery cell 20. In some embodiments, the end cover 21 may be further provided with a pressure relief mechanism used for relieving internal pressure when the internal pressure or temperature of the battery cell 20 reaches a threshold. The end cover 21 may be made of various materials, such as copper, iron, aluminum, stainless steel, an aluminum alloy and plastic, which is not particularly limited in this embodiment of the present application. In some embodiments, an insulating member may be further arranged on an inner side of the end cover 21 and may be used for isolating an electrical connection component in the case 22 from the end cover 21, thereby reducing the risk of short circuit. Exemplarily, the insulating member may be plastic, rubber or the like.

The case 22 is an assembly used to be matched with the end cover 21 to form the internal environment of the battery cell 20, where the formed internal environment can be used to accommodate the cell assembly 23, an electrolyte and other components. The case 22 and the end cover 21 may be separate components, the opening may be formed in the case 22, and at the opening, the opening is covered with the end cover 21 so as to form the internal environment of the battery cell 20. Without limitation, the end cover 21 and the case 22 may also be integrated. Specifically, the end cover 21 and the case 22 may form a common connection surface before other components enter the case. When an interior of the case 22 is required to be encapsulated, the case 22 is covered with the end cover 21. The case 22 may be in various shapes and sizes, such as a rectangular solid, a cylinder and a hexagonal prism. Specifically, the shape of the case 22 may be determined according to the specific shape and size of the cell assembly 23. The case 22 may be made of various materials, such as copper, iron, aluminum, stainless steel, an aluminum alloy and plastic, which is not particularly limited in this embodiment of the present application.

The cell assembly 23 is a component in which the battery cell 100 undergoes an electrochemical reaction. One or more cell assemblies 23 may be contained in the case 22. The cell assembly 23 is mainly formed by winding or stacking a positive electrode sheet and a negative electrode sheet, and a separator is usually arranged between the positive electrode sheet and the negative electrode sheet. The portions, with active materials, of the positive electrode sheet and the negative electrode sheet constitute a main body part of the cell assembly, and the portions, without the active materials, of the positive electrode sheet and the negative electrode sheet respectively constitute tabs 23a. The positive electrode tab and the negative electrode tab may be located at one end of the main body part together or at two ends of the main body part respectively. In the charging and discharging process of the battery, the positive electrode active material and the negative electrode active material react with the electrolyte solution, and the tabs 23a are connected to the electrode terminals to form a current loop.

The BMS 202 includes assemblies such as a current sensor, a pre-charge resistor and a fuse. The BMS is connected to each battery cell 201, and is configured to detect the battery parameters of each battery cell 201 in the battery group to determine the state of the entire battery, and perform corresponding control adjustment and strategy implementation on the battery according to the state of each battery cell 201, thereby realizing charging and discharging management on each battery cell 201 to ensure the safe and stable operation of the battery. Because the BMS 202 is also connected to the wireless management module 102 for sending the collected battery parameters to the wireless management module 102, and the wireless management module 102 sends the battery data corresponding to the battery parameters to the external device.

In this embodiment of the present application, the BMS is connected to the wireless management module, such that the wireless management module can send the battery parameters, monitored by the BMS, of the battery cell to the external device through wireless communication, thereby improving the convenience of data transmission.

Based on the above embodiment, the wireless management module is configured to convert the signal type of the command data into the signal type adaptive to the BMS, and send the converted command parameters to the BMS.

In a specific implementation process, the wireless management module is configured to convert wireless signals into data of signal types that can be recognized by the BMS. The wireless signals may be WIFI signals, 4G network signals, 5G network signals, or Bluetooth signals, or the like. The signal type that the BMS can recognize may be serial port data. Therefore, the wireless management module converts the signal type of the command data into the serial port data after receiving the command data sent by the external device with the signal type being the wireless signals, and sends the converted command parameters to the BMS.

Similarly, after collecting the battery parameters of the battery, the BMS sends the battery parameters with the signal type being the serial port data to the wireless management module, and the wireless management module converts the signal type of the battery parameters into the wireless signals, and sends the converted battery data to the external device.

In another embodiment, after collecting the battery parameters of the battery, the BMS sends the battery parameters with the signal type being the serial port data to the wireless management module, and sends the battery data corresponding to the battery parameters to the external device. Because a wireless management module is also arranged in the external device, and after receiving the battery parameters with the signal type being the serial port data, the wireless management module converts the signal type of the battery parameters into the wireless signals that the external device can recognize.

In this embodiment of the present application, because the signal type of the command data received by the wireless management module from the external device is the wireless signal, to facilitate the BMS to recognize the command data, the wireless management module converts wireless information into the signal type that the BMS can recognize.

Based on the above embodiment, the wireless management module is further connected to a power supply to adjust a sampling voltage of the power supply, and wake up the BMS through the adjusted sampling voltage.

In a specific implementation process, Fig. 4 is a structural diagram of a connection between a battery and a power supply according to an embodiment of the present application. As shown in Fig. 4, the external device includes a wireless communication module and an upper computer. A power interface of the wireless management module 102 is connected to a power supply 401. Because a sampling voltage output by the power supply 401 may not meet the requirements of the BMS, may be higher than the voltage that the BMS can withstand, or lower than the voltage required by the BMS, or may be unstable. Therefore, the wireless management module 102 may adjust the sampling voltage output by the power supply 401, so as to output a relatively stable sampling voltage to the BMS 202. The stable sampling voltage may be used to wake up the BMS 202, and may also supply power to the BMS 202.

In this embodiment of the present application, the wireless management module may wake up the BMS by connecting to the power supply, so as to prepare for sending battery data to the external device later.

Based on the above embodiment, the power supply described in the above embodiment may be a battery module; the wireless management module is connected to a low-voltage interface of the battery module through a first wire harness; and it can be understood that the low-voltage interface refers to an interface whose output voltage is lower than a preset voltage.

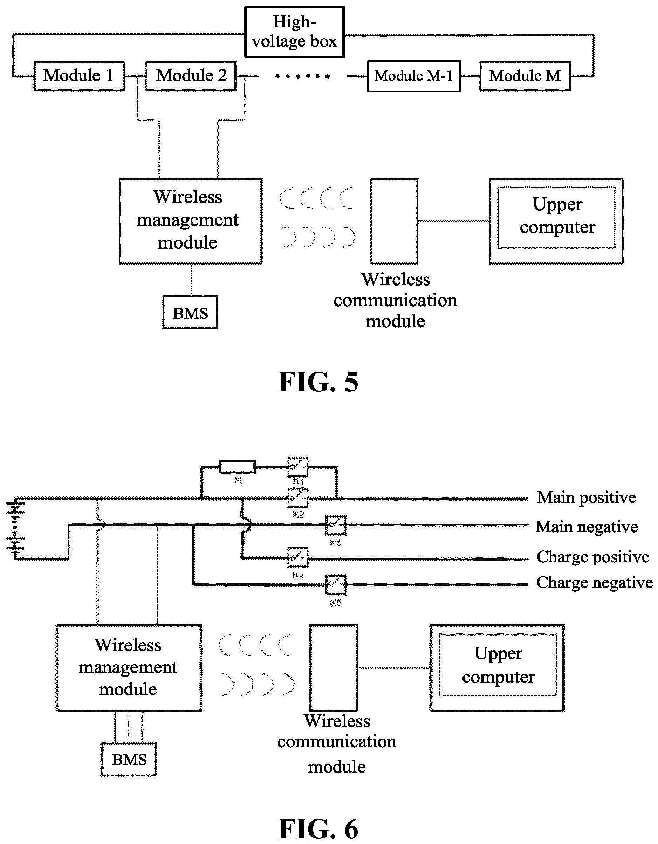

In a specific implementation process, Fig. 5 is a structural diagram of another connection among a battery, a power supply and an external device according to an embodiment of the present application. As shown in Fig. 5, the external device includes a wireless communication module and an upper computer. The power supply may be a battery module, and the battery module may be a battery module constituting the battery described in this embodiment of the present application. The battery module includes a low-voltage interface, and the low-voltage interface is used to output an output voltage lower than a preset voltage. The preset voltage may be 20V, or 24V, or the like. The wireless management module is connected to the low-voltage interface of the battery module through a first wire harness, such that the battery module can be used to supply power to the wireless management module. It can be understood that the low-voltage interface may include a positive interface and a negative interface, and the first wire harness may include a first positive wire and a first negative wire. The wireless management module and the battery module are connected by connecting the first positive wire to the positive interface, and connecting the first negative wire to the negative interface.

In this embodiment of the present application, the wireless management module is connected to the low-voltage interface of the battery module through the first wire harness, so as to realize the function of supplying power to the battery.

Based on the above embodiment, the wireless management module may be connected to a high-voltage loop of the battery through a second wire harness.

Fig. 6 is a structural diagram of another connection among a battery, a power supply and an external device according to an embodiment of the present application. As shown in Fig. 6, A relay internal test main loop in the battery according to this embodiment of the present application includes a pre-charge resistor R and five relays. The five relays are respectively a relay K1, a relay K2, a relay K3, a relay K4 and a relay K5. The pre-charge resistor R is connected to the relay K2 in parallel after being connected to the relay K1 in series, and the pre-charge resistor R is configured to protect the relay K2 and the relay K3. The relay K1 and the relay K2 are arranged on a main positive line, and the main positive line is led out from a positive electrode of the battery to be connected to a positive electrode of a whole vehicle motor. The relay K3 is arranged on a main negative line, and the main negative line is led out from a negative electrode of the battery to be connected to a negative electrode of the whole vehicle motor. The relay K4 is arranged on a charge positive line, and the charge positive line is led out from the positive electrode of the battery to be connected to a positive electrode of a charging pile. The relay K5 is arranged on a charge negative line, and the charge negative line is led out from the negative electrode of the battery to be connected to a negative electrode of a charging pile. The wireless management module is connected to the main positive line and the main negative line through a second wire harness, and a high-voltage loop of the battery wakes up the BMS to supply power to the wireless management module.

In this embodiment of the present application, the wireless management module is connected to the high-voltage loop of the battery through the second wire harness, such that the high-voltage loop of the battery supplies power to a low-voltage loop of the battery.

Based on the above embodiment, the battery is used to be in communication connection with a test terminal, and before the battery arrives at a test station, or after the battery arrives at the test station, or after the battery leaves the test station, testing of wireless test items is started.

In a specific implementation process, the test station is arranged on a battery production line, and the test station is used to test relevant performance of the battery that is about to be off the line, so as to judge whether the battery meets preset requirements or not. The method for testing the battery on the test work includes: after the battery arrives at the test station, a probe on the test station is connected to the battery, so that the connection with the battery can be realized through the probe, and at the time, each test item can be performed according to a preset test process. However, since there are many test items before the battery is off the line, the test time of each battery on the test station is relatively long. In order to test batteries from the previous process in time, the current method is to increase test stations, which will increase test cost. If the test work is not increased, the overall test efficiency is low. In order to solve this technical problem, the inventor of the present application divides the pre-offline test on the battery into a wired test and a wireless test. The so-called wired test refers to the test completed by connecting the probe to the battery on the test station, and the wireless test refers to the test completed by wireless communication through the communication connection between the battery and the external test terminal. Therefore, based on the batteries provided in the above-mentioned embodiments, this embodiment of the present application provides a wireless testing method for the above-mentioned battery with a wireless communication function. Since the wireless test is not affected by the location of the battery, the wireless test can be completed before the battery arrives at the test station, for example, the wireless test can be started when the battery arrives at an upper cover installation station, and the wireless test can be completed before the battery arrives an air tightness test station. When the battery is located at the test station, the battery may be tested in parallel with the test items of the wired test. It is also possible to start the test after the battery completes the wired test on the test station and leaves the test station, for example, the wireless test starts after the battery leaves the test station, and the wireless test is completed before the battery arrives at a lifting station.

It should be noted that the battery provided in this embodiment of the present application is not only suitable for the pre-offline test, but also suitable for the test before shipment and after sale, which is not specifically limited in this embodiment of the present application.

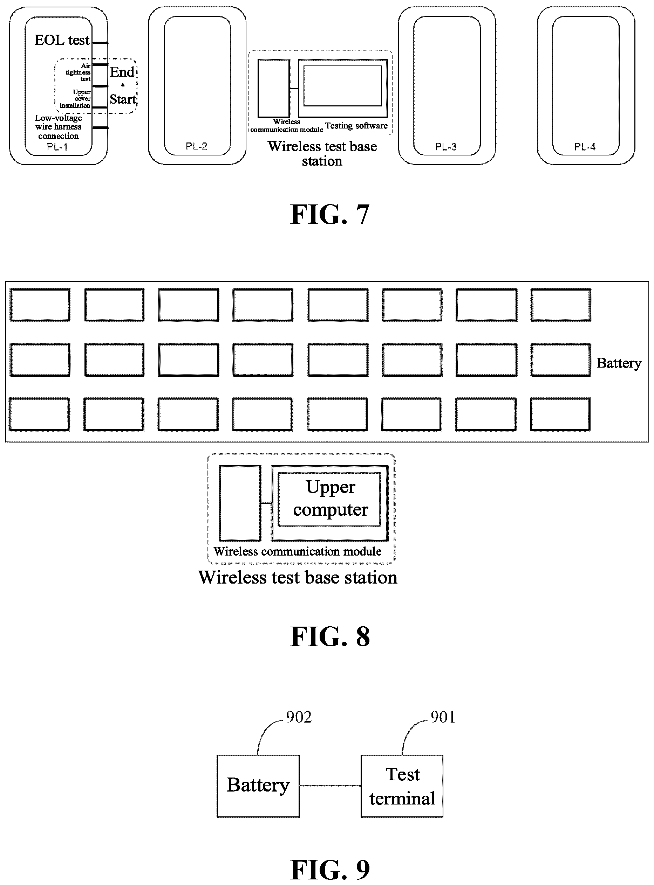

Fig. 7 is a schematic diagram of a semi-finished product test according to an embodiment of the present application. As shown in Fig. 7, four production lines, namely PL1-PL4, are arranged in a workshop. A test terminal is arranged in the workshop, and includes an upper computer and a wireless communication module, and testing software runs in the upper computer. It can be understood that, in the workshop, two or more test terminals may also be set, and this embodiment of the present application does not specifically limit the number of test terminals. For ease of understanding, the present application uses one test terminal as an example for the following introduction. The test terminal may be regarded as a wireless test base station, which communicates with a plurality of wireless management modules on a plurality of production lines respectively. Therefore, the wireless test may be performed on a plurality of batteries at the same time, and the wireless test between the plurality of batteries does not interfere with each other. The application scenario of this embodiment of the present application is to complete the wireless test in the process from installing an upper cover of the battery to the air tightness test, which is called an EOL test. The specific method process is as follows:
Step 1: After the wireless management module is connected to a power supply, the wireless management module starts to work, the wireless management module receives a connection request from the wireless test base station, and establishes a wireless communication connection between the wireless test base station and the battery.
Step 2: After the wireless communication connection is established, the wireless management module wakes up the BMS in reverse, and the BMS starts to send product information, such as bar code of the battery, to the wireless test base station.
Step 3: After receiving the product information, the wireless test base station verifies the product information to determine whether the battery corresponding to the product information is a battery required to be tested wirelessly or not.
Step 4: If the wireless test base station determines that the battery is required to be tested wirelessly, a test command is sent to the battery.
Step 5: The battery receives the test command through the wireless management module, and sends test data corresponding to the test command to the wireless test base station through the wireless management module.
Step 6: The wireless test base station judges the test data to generate a test result corresponding to the test command. Steps 5-6 are cyclically performed until testing of all wireless test items is finished.
Step 7: After the wireless test is completed, the wireless test base station uploads the test result to a manufacturing execution system (MES) according to the product bar code, and sends a disconnection instruction to the battery to disconnect the communication connection between the wireless test base station and the battery.

Fig. 8 is a schematic diagram of a pre-shipment detection of finished products in stock according to an embodiment of the present application. As shown in Fig. 8, when the finished products in stock are shipped, it is necessary to test various performance parameters of the finished batteries. A test terminal is arranged in a warehouse, and includes an upper computer and a wireless communication module, and testing software runs in the upper computer. It can be understood that, in the warehouse, two or more test terminals may also be set, and this embodiment of the present application does not specifically limit the number of test terminals. For ease of understanding, the present application uses one test terminal as an example for the following introduction. The test terminal may be regarded as a wireless test base station, which is in communication connection with wireless management modules of a plurality of batteries respectively. Therefore, the wireless test may be performed on the plurality of batteries at the same time, and the wireless test between the plurality of batteries does not interfere with each other. It should be noted that the pre-shipment test of the finished products in stock is similar to the above method of the semi-finished product test, and will not be repeated here.

This embodiment of the present application uses the wireless test method, which improves the flexibility of the test, reduces the number of test items of a wired test through electrical connection on the test station, and shortens the test time on the test station.

Based on the above embodiment, the wireless test items include at least one of a BMS master control test, a BMS slave control test, a minimum voltage test, a maximum voltage test, a minimum temperature test, a maximum temperature test, an SOC detection, an interlocking signal fault detection, a trickle charge function detection and a fast-charging function detection.

In a specific implementation process, a BMS master control test command is used to detect whether a power supply function or communication function of a BMS master control in the battery-to-be-tested is normal or not, and is used to obtain the software version of the BMS master control in the battery-to-be-tested so as to judge whether the software version is the same as a standard version in the test terminal or not.

A BMS slave control test command is used to detect a power supply function and a communication function of a BMS slave control in the battery-to-be-tested, and whether slave control connection is normal or not.

A minimum voltage test command is used to collect the minimum voltage of the battery-to-be-tested so as to detect whether the minimum voltage is within a preset minimum voltage range or not.

A maximum voltage test command is used to collect the maximum voltage of the battery-to-be-tested so as to detect whether the maximum voltage is within a preset maximum voltage range or not.

A minimum temperature test command is used to collect the minimum temperature of the battery-to-be-tested so as to detect whether the minimum temperature is within a preset minimum temperature range or not.

A maximum temperature test command is used to collect the maximum temperature of the battery-to-be-tested so as to detect whether the maximum temperature is within a preset maximum temperature range or not.

An SOC detection command is used to collect an SOC value of the battery-to-be-tested to so as to detect whether the SOC value is within a preset SOC range or not.

An interlocking signal fault detection command controls the on-off of an interlocking signal line, and sends a corresponding state of the BMS to the test terminal through the wireless management module so as to detect whether an interlocking signal is in failure or not.

A trickle charge function detection command detects, through additional enable signals CC and CP, whether a trickle charge function is normal or not.

A fast-charging function detection command detects, through additional enable signals CC2, whether a fast-charging function is normal or not.

In this embodiment of the present application, the above-mentioned test items capable of being completed through wireless communication are used to realize data interaction between the battery-to-be-tested and the test terminal by using the wireless management module, and complete the wireless test, thereby reducing the test items of the wireless test on the battery-to-be-tested on the test station, and improving test efficiency.

An embodiment of the present application further provides an electrical apparatus, including the battery according to the above-mentioned embodiments. The battery can not only be used to supply power to the electrical apparatus, but also establish wireless communication with an external device through a wireless management module, and send battery data corresponding to battery parameters to the external device through wireless communication.

It can be understood that the functions of the battery and the battery data sent by the battery to the external device may refer to the above-mentioned embodiments, and details are not repeated here. This embodiment of the present application provides the electrical apparatus that uses the battery as a power supply, and the electrical apparatus may be but not limited to a mobile phone, a tablet, a laptop, an electric toy, an electric tool, a battery vehicle, an electric vehicle, a ship, a spacecraft, etc. The electric toy may include fixed or mobile electric toys, such as game consoles, electric vehicle toys, electric ship toys, electric airplane toys, etc. The spacecraft may include airplanes, rockets, space shuttles, spaceships, etc.

In this embodiment of the present application, by using the battery with the wireless communication function, the battery parameters of the battery installed on the electrical apparatus can be conveniently obtained.

Fig. 9 is a schematic structural diagram of a battery testing system according to an embodiment of the present application. As shown in Fig. 9, the system includes a test terminal 901 and the battery 902 provided in the above-mentioned embodiments. The battery 902 is in wireless communication connection with the test terminal 901 through a wireless management module, and receives, by the wireless management module, a test command sent by the test terminal 901, acquires corresponding battery parameters according to the test command, and sends, by the wireless management module, test data corresponding to the battery parameters to the test terminal 901.

In a specific implementation process, the test terminal may be a terminal with a wireless communication function, such as a smart phone, a tablet, a computer, a personal digital assistant (Personal Digital Assistant, PDA), etc. Therefore, the test terminal 901 also includes a wireless communication functional unit. Of course, the test terminal 901 may also be a terminal without a wireless communication function, such as an upper computer without a wireless communication function. For the test terminal 901 without the wireless communication function, the test terminal 901 may be in communication connection with the wireless management module in the battery 902 through an external wireless communication unit. In the test terminal 901, testing software may be pre-installed, and test cases for each test item for the wireless test on the battery 902 are pre-configured in the testing software. It can be understood that the test cases of each test item may be independent, or may be combined into a complete test case according to a certain test sequence.

After the battery 902 establishes the communication connection with the test terminal 901 through the wireless management module, the test terminal 901 may send, by the running testing software, the test command to the battery 902 according to a preset test sequence. It can be understood that the test command may be at least one of a BMS master control test command, a BMS slave control test command, a minimum voltage test command, a maximum voltage test command, a minimum temperature test command, a maximum temperature test command, an SOC detection command, an interlocking signal fault detection command, a trickle charge function detection command and a fast-charging function detection command. The battery 902 obtains corresponding battery parameters according to the different received test commands, and returns test data corresponding to the battery parameters to the test terminal. Standard indicators corresponding to the test commands are preset in the test terminal 901. The test terminal 901 receives the test data and compares the test data with the standard indicators, so as to determine whether the battery 902 passes a test item corresponding to the test command and generate a test result.

In addition, the test terminal 901 may also be in communication connection with a manufacturing execution system (manufacturing execution system, MES), and upload the test result to the MES.

In this embodiment of the present application, the battery is in wireless communication connection with the test terminal through the wireless management module, such that the wireless test on the battery-to-be-tested can be realized, thereby reducing test items of a wired test on a test station, reducing a test cycle on the test station, and improving test efficiency.

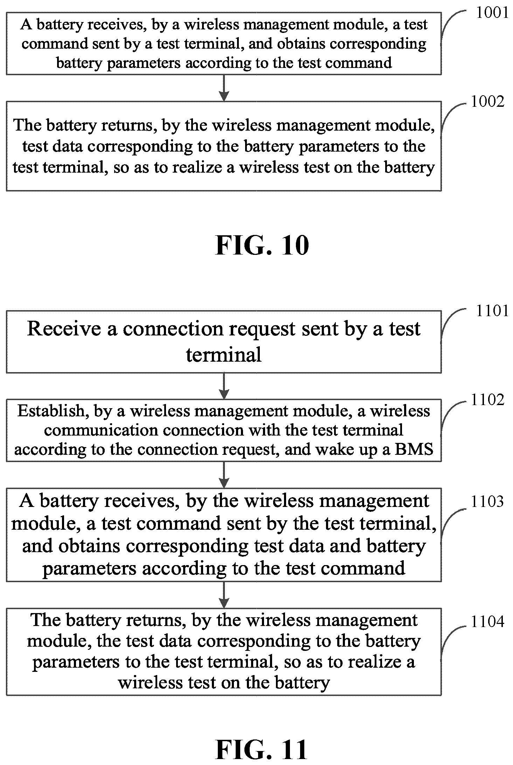

Fig. 10 is a schematic flowchart of a battery testing method according to an embodiment of the present application. As shown in Fig. 10, the method can be applied to testing the battery described in the above embodiment, and the battery includes a wireless management module. The method includes:
Step 1001: The battery receives, by the wireless management module, a test command sent by a test terminal, and obtains corresponding battery parameters according to the test command.
Step 1002: The battery returns, by the wireless management module, test data corresponding to the battery parameters to the test terminal, so as to realize a wireless test on the battery.

In step 1001, the related introduction of the wireless management module may refer to the above-mentioned embodiments, which will not be repeated here. After the wireless management module establishes a wireless communication connection with the test terminal, data wireless transmission methods of the wireless management module include but not limited to WIFI, 5G, Bluetooth, ZigBee, near field communication (Near Field Communication, NFC) and ultra wide band (Ultra Wide Band, UWB).

The battery may receive, by the wireless management module, the test command sent by the test terminal. The test command is a command for testing the battery and may be generated according to test cases pre-configured in the test terminal. It can be understood that test items corresponding to different types of batteries may be different, so that corresponding test cases are also different, and as a result, test commands are also different.

After receiving the test command, the wireless management module in the battery performs operation such as parse on the test command, obtains command parameters corresponding to the test command, and sends the command parameters to the BMS, and the BMS obtains corresponding battery parameters according to the command parameters. For example: the test command is to obtain a maximum temperature of the battery, and the BMS packages parameter information including the maximum temperature into battery parameters. It can be understood that the process of converting, by the wireless management module, the test command into the command parameters is consistent with the process of converting the command data into the command parameters in the above embodiment, which will not be repeated here.

In step 1002, the BMS sends the battery parameters to the wireless management module, and the wireless management module returns the test data corresponding to the battery parameters to the test terminal. The test terminal judges, according to the test data, whether the test items corresponding to the battery meet the requirements or not, so as to realize the wireless test on the battery. Similarly, in this embodiment of the present application, the process of converting, by the wireless management module, the battery parameters into the test battery data is consistent with the process of converting the battery parameters into the battery data in the above-mentioned embodiment, which will not be repeated here.

It can be understood that before step 1001, the process of verifying the battery by the test terminal may also be included, that is, after the battery establishes the wireless communication connection with the test terminal, the battery may send verification information to the test terminal through the wireless management module, and the verification information includes bar code of the battery, it can be understood that each battery has globally unique bar code, and the test terminal can determine, according to the bar code, whether the battery in communication connection therewith is the battery required to be tested.

This embodiment of the present application implements the battery test through wireless communication, accordingly, the test items capable of being performed through the wireless test can be performed before the battery arrives at a test station, or after the battery leaves the test station, or may be performed in parallel with a wired test on the test station, such that the test items on the test station are reduced, thereby reducing a test cycle on the test station and improving test efficiency.

Based on the above embodiment, the test terminal monitors position information of the battery, and if the position information represents that the battery arrives at a preset station, the test command is sent to the wireless management module.

The test terminal is in communication connection with a transportation apparatus for transporting batteries. The transportation apparatus stores an identifier of the transportation apparatus and bar code of the transported batteries. The transportation apparatus has a positioning function, which can send the location to the test terminal, such that the test terminal can monitor the position information of the batteries. When the test terminal monitors that the battery arrives at the preset station, the test command can be sent to the wireless communication module to start the wireless test.

In this embodiment of the present application, the test terminal monitors the position of the battery-to-be-tested and starts the wireless test after the battery arrives at the preset station, such that part of test items are performed through the wireless test, which does not occupy test time on the test station, thereby improving test efficiency.

Fig. 11 is a schematic flowchart of another battery testing method according to an embodiment of the present application. As shown in Fig. 11, the method includes:
Step 1101: A connection request sent by a test terminal is received.
Step 1102: A wireless communication connection with the test terminal is established by a wireless management module according to the connection request, and a BMS is awakened.
Step 1103: A battery receives, by the wireless management module, a test command sent by the test terminal, and obtains corresponding battery parameters according to the test command.
Step 1104: The battery returns, by the wireless management module, test data corresponding to the battery parameters to the test terminal, so as to realize a wireless test on the battery.

In step 1101, before the wireless test is performed on the battery, the connection between the test terminal and the battery is required to be established, such that the test terminal sends the connection request to the battery.

In step 1102, after receiving the connection request through the wireless management module, the battery establishes the wireless communication connection with the test terminal through the wireless management module. After the wireless communication connection is established, the wireless management module sends a voltage signal to the BMS to wake up the BMS.

It should be noted that step 1103 and step 1104 respectively correspond to step 1001 and step 1002 in the above-mentioned embodiment, and details are not repeated here.

In this embodiment of the present application, the wireless communication connection with the test terminal is established by the wireless management module, so as to provide a communication basis for the subsequent wireless test.

Based on the above embodiment, the test command includes at least one of a BMS master control test command, a BMS slave control test command, a minimum voltage test command, a maximum voltage test command, a minimum temperature test command, a maximum temperature test command, an SOC detection command, an interlocking signal fault detection command, a trickle charge function detection command and a fast-charging function detection command.

It should be noted that the above-mentioned test commands correspond to the test items in the above-mentioned embodiments. Therefore, the functions of the test commands may refer to the explanations for the test items in the above-mentioned embodiments, which will not be repeated here.

In this embodiment of the present application, the above-mentioned test items capable of being completed through wireless communication are used to realize data interaction between the battery-to-be-tested and the test terminal by using the wireless management module, and complete the wireless test, thereby reducing the test items of the wireless test on the battery-to-be-tested on the test station, and improving test efficiency.

An embodiment of the present application provides a wireless testing method for a battery, specifically including:
after the battery-to-be-tested completes all low-voltage connections, a wireless management unit is in a working state and continues to send data to the outside;
after base station software running on a test terminal is opened, a test server is automatically created until the software is closed;
after the test terminal is connected to the battery-to-be-tested, a test thread is created, and after a wireless management module of the battery-to-be-tested detects the creation of the test thread, the BMS is awakened in reverse (through a 12V power supply), and the wireless test is started;
after the test terminal is connected to the battery-to-be-tested, the battery-to-be-tested actively sends an automated guided vehicle (AGV) number to the test terminal, and the test terminal obtains bar code of the battery-to-be-tested from an AGV database according to the AGV number; it should be noted that during testing in a finished product warehouse, since the battery is not placed on an AGV at the time, the battery bar code is not bound with the AGV, a base station only needs to send a command for reading the bar code of the battery-to-be-tested to the wireless management module, and then the wireless management module is used as a bridge to transmit the command to the BMS, and accordingly the bar code of the battery-to-be-tested is obtained;
the test terminal extracts PN code (partnumber, partnumber of a product-to-be-tested) of the battery according to the bar code of the battery-to-be-tested;
according to the PN code of the battery-to-be-tested, the test terminal calls a corresponding test formula from a built-in test formula library in wireless testing software (the test formula in the test formula library is bound with the product PN, and different product PNs are different in test formula);
the test terminal tests the battery-to-be-tested according to the test formula selected from the test formula library according to the PN code of the battery-to-be-tested;
if the corresponding test formula is not found in the test formula library, the test terminal should give an exception prompt;
test threads do not interfere with each other, and the exception of one test thread cannot affect other test threads; and
after the test is completed, the test thread sends a test completion command to the battery-to-be-tested, and after a delay for a period of time, the test terminal actively disconnects from the battery-to-be-tested.

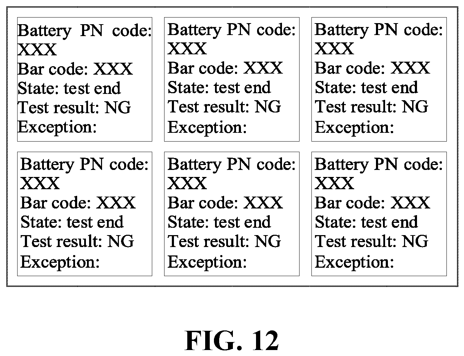

Fig. 12 is a schematic diagram of a display interface of a test terminal according to an embodiment of the present application. A base station display is divided into grids; and each grid corresponds to a test thread. When the grid is clicked, a test progress window can pop up; the test progress window displays a complete test formula and a test progress test result. The grid may be filled with different colors for different test states, which facilitates a user to check. For example: NG (test failed) the grid is displayed in red; OK (test passed) the grid is displayed in green; the test is in progress: the grid is displayed in yellow; no formula: the grid is displayed in blue; and in the test NG grid, after a reset command of the battery-to-be-tested is received, the battery-to-be-tested is disconnected.

It should be noted that the grid shown in Fig. 12 is just an example, the number of grids displayed in the display interface, and the content displayed in each grid may be pre-configured according to the actual situation, which are not specifically limited in this embodiment of the present application.

In the embodiments provided in the present application, it should be understood that the disclosed apparatus and method may be implemented in other manners. The above-mentioned described apparatus embodiment is merely an example. For example, the unit division is merely a logical function division, and there may be other division ways during actual implementation. For another example, a plurality of units or components may be combined or integrated into another system, or some features may be ignored or not performed. On the other hand, the shown or discussed mutual coupling or direct coupling or communication connection may be indirect coupling or communication connection through some interfaces, apparatuses, or units, and may be in electrical, mechanical, or in other forms.

In addition, the units described as separate components may or may not be physically separated, and the components for unit display may or may not be physical units, and may be located in one place or may be distributed over a plurality of network units. Some or all of the units may be selected according to actual needs to achieve the objective of the solution of this embodiment.

Further, functional modules in the embodiments of the present application may be integrated to form an independent part, or may exist independently, or two or more modules may be integrated to form an independent part.

Herein, relational terms such as "first" and "second" are used only to distinguish one entity or operation from another and do not necessarily require or imply any actual relationship or order between these entities or operations.

The above descriptions are merely the embodiments of the present application and are not used to limit the scope of protection of the present application, and the present application can be variously modified and changed for those skilled in the art. Any modification, equivalent replacement, improvement, etc. made within the spirit and the principle of the present application shall fall within the scope of protection of the present application.

## Claims

1. A battery, comprising: a battery module and a wireless management module, wherein the wireless management module is configured to provide communication between the battery module and an external device; and
the wireless management module receives command data sent by the external device, sends command parameters to the battery module, receives battery parameters sent by the battery module, and sends battery data to the external device.

2. The battery according to claim 1, wherein the battery module comprises a battery cell and a battery management system (BMS);
the BMS is respectively connected with the battery cell and the wireless management module; and
the BMS is configured to collect battery parameters of the battery cell, and send battery data corresponding to the battery parameters to the wireless management module.

3. The battery according to claim 2, wherein the wireless management module is configured to convert the signal type of the command data into a signal type adaptive to the BMS, and send converted command parameters to the BMS.

4. The battery according to claim 2 or 3, wherein the wireless management module is also connected to a power supply to adjust a sampling voltage of the power supply, and use the adjusted sampling voltage to wake up the BMS.

5. The battery according to claim 4, wherein the power supply is a battery module; the wireless management module is connected to a low-voltage interface of the battery module through a first wire harness; and the low-voltage interface refers to an interface whose output voltage is lower than a preset voltage.

6. The battery according to any one of claims 3 to 5, wherein the wireless management module is connected to a high-voltage loop of the battery through a second wire harness.

7. The battery according to any one of claims 1 to 6, wherein the battery is used to be in communication connection with a test terminal, and before the battery arrives at a test station, or after the battery arrives at the test station, or after the battery leaves the test station, testing of wireless test items is started.

8. The battery according to claim 7, wherein the wireless test items comprise at least one of a BMS master control test, a BMS slave control test, a minimum voltage test, a maximum voltage test, a minimum temperature test, a maximum temperature test, an SOC detection, an interlocking signal fault detection, a trickle charge function detection and a fast-charging function detection.

9. An electrical apparatus, comprising the battery according to any one of claims 1 to 8, wherein the battery is used to provide electric energy and send, through wireless communication, battery data corresponding to battery parameters to an external device.

10. A battery testing system, comprising a test terminal and the battery according to any one of claims 1 to 8;
wherein the battery is in wireless communication connection with the test terminal through a wireless management module; and
the battery receives, by the wireless management module, a test command sent by the test terminal, acquires corresponding battery parameters according to the test command, and sends, by the wireless management module, test data corresponding to the battery parameters to the test terminal.

11. A battery testing method, wherein the battery comprises a wireless management module, and the method comprises:
receiving, by the wireless management module, a test command sent by a test terminal, and acquiring corresponding battery parameters according to the test command; and
returning, by the wireless management module, test data corresponding to the battery parameters to the test terminal, so as to realize a wireless test on the battery.

12. The method according to claim 11, wherein the test terminal monitors position information of the battery, and in a case where the position information represents that the battery arrives at a preset station, the test command is sent to the wireless management module.

13. The method according to claim 11 or 12, wherein before the wireless management module receives the test command sent by the test terminal, the method further comprises:
receiving a connection request sent by the test terminal; and
establishing, by the wireless management module, a wireless communication connection with the test terminal according to the connection request, and waking up a BMS.

14. The method according to any one of claims 11 to 13, wherein the test command comprises at least one of a BMS master control test command, a BMS slave control test command, a minimum voltage test command, a maximum voltage test command, a minimum temperature test command, a maximum temperature test command, an SOC detection command, an interlocking signal fault detection command, a trickle charge function detection command and a fast-charging function detection command.
